Europäisches Patentamt

European Patent Office

Office européen des brevets

(11) Veröffentlichungsnummer: **0 179 472**
A2

## (12) EUROPÄISCHE PATENTANMELDUNG

(21) Anmeldenummer: 85113528.5

(22) Anmeldetag: 24.10.85

(51) Int. Cl.⁴: **H 01 J 61/56**

(30) Priorität: 25.10.84 DE 3439171

(43) Veröffentlichungstag der Anmeldung:
30.04.86 Patentblatt 86/18

(84) Benannte Vertragsstaaten:
DE FR GB IT

(71) Anmelder: Patent-Treuhand-Gesellschaft für elektrische
Glühlampen mbH
Hellabrunner Strasse 1
D-8000 München 90(DE)

(72) Erfinder: Wittmann, Horst, Dipl.-Ing. (FH)
Ahornweg 22
D-8901 Stadtbergen(DE)

(54) **Einseitig gesockelte Quecksilberdampfniederdruckentladungslampe.**

(57) Die benachbarten Enden des Entladungsgefäßes (5)
münden in einen Sockelkörper (1), der aus einem Oberteil (2)
sowie einem Unterteil (3) besteht und an dessen unterem
Bereich ein Sockel (9) befestigt ist. Innerhalb des Sockelkörpers (1) ist eine auf einer Montageplatte (7) angeordnete Vor-
schalt- und Zündvorrichtung (8) vorgesehen. Zur
Kontaktierung einer Stromzuführung (12) mit der Hülse des
Sockels (9) ist diese von der Montageplatte (7) durch den
Innenraum des Sockelkörpers (1) geführt und dann durch
eine im unteren Bereich des Sockelkörpers (1) stirnseitig angeordnete Nut (13) nach außen gebogen. Durch das Befestigen des Sockels (9) ist die Stromzuführung (12) in der Nut
(13) lagegesichert und zwischen der Hülse des Sockels (9)
und dem unteren Bereich des Sockelkörpers (1) kontaktierend
festgeklemmt.

FIG.1

Patent-Treuhand-Gesellschaft
für elektrische Glühlampen mbH., München


**Einseitig gesockelte Quecksilberdampfniederdruckentladungslampe**

Die Erfindung betrifft eine einseitig gesockelte Quecksilberdampfniederdruckentladungslampe, bestehend aus einem oder mehreren Entladungsgefäßen, an dessen Enden Stromzuführungen herausgeführt sind, und einem zumindest die Enden des Entladungsgefäßes umgebenden und mit diesem unlösbar verbundenen Sockelkörper, an dessen dem Entladungsgefäß abgewandten Teil ein für Glühlampen gebräuchlicher Sockel befestigt ist, wobei der Sockelkörper eine mit Stromzuführungen versehene Vorschalt- und Zündvorrichtung enthält und Stromzuführungen des Entladungsgefäßes und/oder der Vorschalt- und Zündvorrichtung am Sockel befestigt sind.

Lampen dieser Art sind als Kompaktleuchtstofflampen aus der Patentliteratur in verschiedenen Ausführungsformen bekannt. Die Kontaktelemente der Sockelhülse bestehen hier aus einer Gewindehülse und einem Bodenkontakt. Je eine Stromzuführung des Entladungsgefäßes und der Vorschalt- und Zündvorrichtung ist elektrischleitend mit der Gewindehülse bzw. mit dem Bodenkontakt des Sockels verbunden. Die Verbindung selbst erfolgt in der Regel mittels einer Weichlötung. Bei maschineller Montage dieser Lampen stellen sich häufig Lötfehler ein, so daß eine personal- und kostenintensive manuelle Nachlötung erforderlich ist. Insbesondere die Seitenlötung an der Gewindehülse ist von solcher Art Lötfehler betroffen. Bei hängender Montage der gesamten Einheit bereitet die Lötung des dann obenliegenden

Bodenkontaktes auch bei maschineller Fertigung dagegen
kaum Schwierigkeiten.

Aufgabe der Erfindung ist es, die Konstruktion des Sok-
kelkörpers derart zu gestalten, daß auch bei maschineller Montage die vorgenannten Lötfehler insbesondere
der Seitenlötung nicht auftreten.

Diese Aufgabe wird bei einer einseitig gesockelten Quecksilberdampfniederdruckentladungslampe mit den im Oberbegriff des Hauptanspruchs genannten Merkmale dadurch
gelöst, daß zur Kontaktierung des Sockels mit mindestens einer Stromzuführung diese zwischen dem Sockel
und dem dem Entladungsgefäß abgewandten Teil des Sok-
kelkörpers durch Klemmung unverrückbar fixiert ist.
Hierfür ist der Sockelkörper an seinem dem Entladungsgefäß abgewandten Teil zur Fixierung der Stromzuführung
mit einer Nut versehen, in der die Stromzuführung angeordnet ist. Die Nut ist vorzugsweise in der Stirnfläche
des sonst hohlzylindrisch ausgebildeten, dem Entladungsgefäß abgewandten Teils des Sockelkörpers vorgesehen.
Die Nut kann aber ebensogut auch in der Mantelfläche des
dem Entladungsgefäß abgewandten Teils des Sockelkörpers
angeordnet sein. Der Sockel ist an dem dem Entladungsgefäß abgewandten Teil des Sockelkörpers vorzugsweise
durch Stanzen befestigt, wodurch die Stromzuführung
von der Innenwand des Sockels am Sockelkörper festgeklemmt ist. Alternativ kann der dem Entladungsgefäß abgewandte hohlzylindrische Teil des Sockelkörpers auch
mit einem dem Sockel entsprechenden Gewinde versehen
sein, so daß der Sockel aufgeschraubt und dadurch die
Stromzuführung in der Nut fixiert wird.

Aus dieser Konstruktion ergeben sich Vorteile für die
Fertigung, wie sie bei den bisher bekannten Ausführungsformen von einseitig gesockelten Kompaktlampen nicht auftreten. Die Stromzuführung ist leicht montierbar, wodurch auch die Voraussetzung für eine fehlerfreie maschinelle und damit kostengünstige Montage gegeben ist. Manuelle Nachlötungen von fehlerhaften Lötverbindungen zwischen der Stromzuführung und dem Seitenkontakt des Sockels sind nicht mehr erforderlich. Die Stromzuführung ist in der Nut gegen Verschiebungen lagegesichert und wird gleichzeitig durch das Aufsetzen des Sockels festgeklemmt, wodurch ein guter elektrischer Kontakt mit hoher elektrischer Sicherheit gewährleistet ist.

Die Erfindung wird nachfolgend anhand eines Ausführungsbeispiels näher erläutert:

Figur 1 zeigt schematisch einen Schnitt durch einen Sockelkörper

Figur 2 zeigt einen Schnitt eines Teils im unteren Bereich des Sockelkörpers

Der Sockelkörper 1 besteht aus Kunststoff und setzt sich aus einem Oberteil 2 und einem Unterteil 3 zusammen, die mittels einer Schnappverbindung 4 mechanisch unlösbar miteinander verbunden sind. An das Oberteil 2 ist das mit Leuchtstoff beschichtete, gebogene Entladungsgefäß 5 mit Hilfe eines durch Temperatur aushärtbaren Kitts 6 befestigt. Das Entladungsgefäß 5 weist eine etwa U-förmige Gestalt auf. Es können aber auch zwei derartige Entladungsgefäße 5 verbunden werden, so daß sich die doppelte Entladungslänge ergibt. In diesem Fall sind die vier geraden Schenkel parallel zueinander und in einem Quadrat angeordnet. Des weiteren können auch mehrere zweischenklige Entladungsgefäße 5 im Sockelkörper 1 befestigt sein.

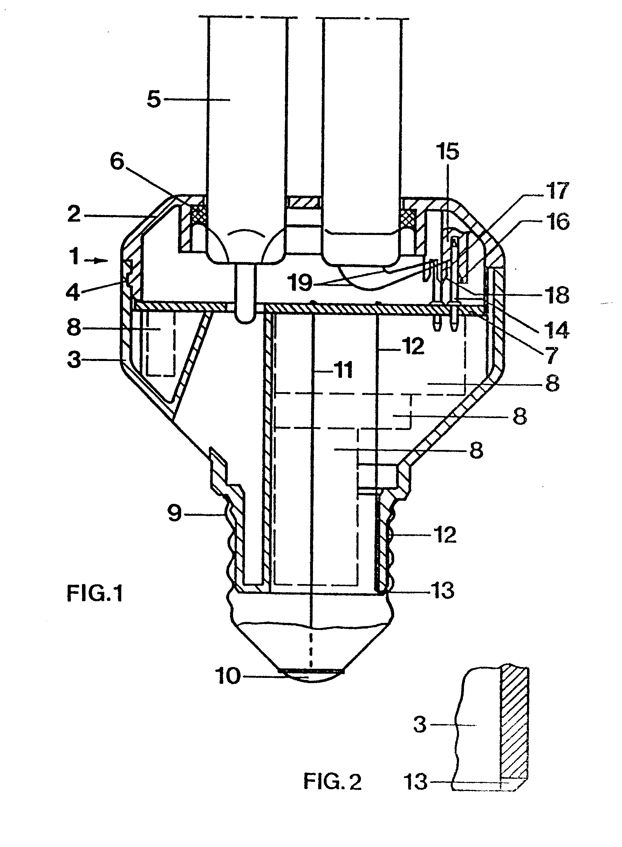

Im Unterteil 3 ist eine Montageplatte 7 befestigt, auf der eine Vorschalt- und Zündvorrichtung 8 montiert ist. Hierfür ist ein induktives Vorschaltgerät mit Starter oder ein elektronisches Vorschaltgerät gleichermaßen geeignet. Im vorliegenden Ausführungsbeispiel ist die Montageplatte 7 eine Leiterplatte, auf der die Bauteile eines Hochfrequenzvorschaltgerätes angeordnet sind. Dieses bietet die Vorteile einer höheren Lichtausbeute der Lampe sowie des gegenüber einem konventionellen Vorschaltgerät wesentlich verringerten Gewichts. Im unteren Bereich des Unterteils 3 ist ein Sockel 9 befestigt, wie er gewöhnlich für Glühlampen verwendet wird. Der Sockel 9 ermöglicht den direkten Anschluß der Kompaktlampe in die Fassung einer für Glühlampen vorgesehenen Leuchte. Am Bodenkontakt 10 des Sockels 9 ist eine erste Stromzuführung 11 angelötet, die durch den Hohlraum im unteren Bereich des Sockelkörpers 1 zur Montageplatte 7 führt. Eine zweite Stromzuführung 12 führt von der Montageplatte 7 ebenfalls durch den Hohlraum im unteren Bereich des Unterteils 3, ist dann weiter an dessen Unterkante nach außen gebogen und liegt dort die Hülse des Sockels 9 kontaktierend an. Am Umkehrpunkt der zweiten Stromzuführung 12 ist das Unterteil 3 mit einer stirnseitigen Nut 13 versehen, in der die Stromzuführung 12 angeordnet und nach dem Befestigen des Sockels 9 durch Stanzen absolut lagegesichert und durch Klemmung fixiert ist (Figur 2). Hierdurch entsteht eine sichere elektrische Verbindung zwischen der zweiten Stromzuführung 12 und der Hülse des Sockels 9.

Die elektrische Verbindung zwischen dem das Entladungsgefäß 5 halternden Oberteil 2 und dem die Vorschalt- und Zündvorrichtung 8 aufnehmenden Unterteil 3 erfolgt über die Kontaktstifte 14. Diese sind in die Montageplatte 7 eingepreßt oder eingelötet und stehen über die Leiterbahnen der Montageplatte 7 in elektrischem Kontakt zu der Vorschalt- und Zündvorrichtung 8. An das Oberteil 2 sind Buchsen 15 angeformt, die an der Öffnung mit einem Einführtrichter 16 versehen sind. Er erleichtert das maschinelle Einsetzen der Kontaktstifte 14 in das konzentrisch zur Buchse 15 angeordnete Sackloch. Des weiteren weist die Buchse 15 einen dieses Sackloch tangierenden Schlitz 17 auf, der an der dem Unterteil 3 zugewandten Seite mit einer Einführschräge 18 versehen ist. Sie erleichtert das maschinelle Einsetzen der Stromzuführungen 19 in den Schlitz 17. Bei der Montage werden - nachdem das Entladungsgefäß 5 mit dem Oberteil 2 des Sockelkörpers 1 verbunden wurde - die Stromzuführungen 19 des Entladungsgefäßes 5 in die Schlitze 17 der Buchsen 15 eingelegt. Die Kontaktstifte 14 wurden zuvor bereits wie oben angegeben mit der Montageplatte 7 verbunden. Beim anschließenden Zusammenfügen des jeweils vorgefertigten Oberteils 2 und des Unterteils 3 werden die Kontaktstifte 14 in die Sacklöcher der Buchsen 15 eingepreßt, wobei gleichzeitig die in den Schlitzen 17 angeordneten Stromzuführungen 19 fixiert und kontaktiert werden. Der hier ausgeführte Montagevorgang gilt in gleicher Weise für alle vier vorhandenen Kontaktstifte 14 und Stromzuführungen 19, von denen in der Zeichnung jedoch nur zwei dargestellt wurden.

Wa/Mg

Patentansprüche

1. Einseitig gesockelte Quecksilberdampfniederdruckentladungslampe, bestehend aus einem oder mehreren Entladungsgefäßen (5), an dessen Enden Stromzuführungen (19) herausgeführt sind, und einem zumindest die Enden des Entladungsgefäßes (5) umgebenden und mit diesem unlösbar verbundenen Sockelkörper (1), an dessen dem Entladungsgefäß (5) abgewandten Teil ein für Glühlampen gebräuchlicher Sockel (9) befestigt ist, wobei der Sockelkörper (1) eine mit Stromzuführungen (11, 12) versehene Vorschalt- und Zündvorrichtung (8) enthält und Stromzuführungen des Entladungsgefäßes (5) und/oder der Vorschalt- und Zündvorrichtung (8) am Sockel (9) befestigt sind, dadurch gekennzeichnet, daß zur Kontaktierung des Sockels (9) mit mindestens einer Stromzuführung (12) diese zwischen dem Sockel (9) und dem dem Entladungsgefäß (5) abgewandten Teil des Sockelkörpers (1) durch Klemmung unverrückbar fixiert ist.

2. Quecksilberdampfniederdruckentladungslampe nach Anspruch 1, dadurch gekennzeichnet, daß zur Fixierung der Stromzuführung (12) der dem Entladungsgefäß (5) abgewandte Teil des Sockelkörpers (1) eine Nut (13) aufweist, in der die Stromzuführung (12) angeordnet ist.

3. Quecksilberdampfniederdruckentladungslampe nach Anspruch 1 und 2, dadurch gekennzeichnet, daß die Nut (13) in der Stirnfläche des sonst hohlzylindrisch ausgebildeten, dem Entladungsgefäß (5) abgewandten Teil des Sockelkörpers (1) angeordnet ist.

4. Quecksilberdampfniederdruckentladungslampe nach An-

spruch 1 bis 3, dadurch gekennzeichnet, daß der
Sockel (9) an dem dem Entladungsgefäß (5) abgewandten Teil des Sockelkörpers (1) durch Stanzen unlösbar befestigt ist, wodurch die Stromzuführung (12)
von der Innenwand des Sockels (9) am Sockelkörper
(1) festgeklemmt wird.

FIG.1

FIG. 2